(19) Europäisches Patentamt
European Patent Office
Office européen des brevets

(11) **EP 4 787 714 A1**

(12) **EUROPEAN PATENT APPLICATION**

(43) Date of publication:
**05.08.2026 Bulletin 2026/32**

(21) Application number: **26152022.5**

(22) Date of filing: **15.01.2026**

(51) International Patent Classification (IPC):
$H03M\ 1/10^{(2006.01)}$ $\quad$ $H03M\ 3/02^{(2006.01)}$
$H03M\ 3/04^{(2006.01)}$ $\quad$ $H03M\ 1/66^{(2006.01)}$
$H03M\ 1/08^{(2006.01)}$ $\quad$ $H03M\ 1/80^{(2006.01)}$

(52) Cooperative Patent Classification (CPC):
**H03M 3/38; H03M 1/1057; H03M 3/464; H03M 1/66; H03M 1/808**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **30.01.2025 IT 202500001626**

(71) Applicant: **STMicroelectronics International N.V.**
**1228 Plan-les-Ouates, Geneva (CH)**

(72) Inventors:
• **COSENTINO, Gaetano**
  **I-95127 Catania (IT)**
• **PIAZZESE, Nicolo' Ivan**
  **I-95024 Acireale (Catania) (IT)**
• **BELLANTONE, Nino Gianfranco**
  **I-95127 Catania (IT)**
• **IMBESI, Pasquale Giuseppe**
  **I-95021 Aci Castello (Catania) (IT)**
• **CALCAGNO, Antonino**
  **I-98168 Messina (IT)**

(74) Representative: **Buzzi, Notaro & Antonielli d'Oulx S.p.A.**
**Corso Vittorio Emanuele II, 6**
**10123 Torino (IT)**

(54) **ELECTRONIC CONVERSION ARCHITECTURE COMPRISING A CONTINUOUS TIME SIGMA DELTA ANALOG TO DIGITAL CONVERTER AND A CALIBRATION METHOD THEREOF**

(57) A conversion architecture (10) comprising a Continuous Time Sigma Delta Analog to Digital Converter (11) comprising a loop filter (111) followed by an analog to digital converter (112) and a feedback loop (113, 113', 116) feeding back the output (v) of said analog to digital converter (112) through an internal digital to analog converter (113; 113') to obtain (110) an error signal (e(t)) with respect to a input signal (u, s(t)), which is fed to said loop filter (111), an output digital signal ($ADC_{out}$) of the analog to digital converter (112) being fed to a decimation chain of decimators (14), a local oscillator (12) feeding a clock signal ($CLK_{ADC}$) to said analog to digital converter (112), and, through a frequency divider (13), to said chain of decimators (14), wherein said conversion architecture (10) further comprises

a circuit arrangement (116; 116, 24) configured to obtain a calibration tone (CT) by a divided frequency (CK3) outputted by said frequency divider (13) to said chain of decimators (14) and inject said calibration tone (CT) in said feedback loop (113', 116), in particular in the input path of said analog to digital converter (112),

a calibration arrangement (22, 23) which comprises

a spurious tone estimation module (22) configured to obtain an estimation (SE) of the power of a spurious tone (2th_spur) in said output signal (v) based on a decimated signal ($v_1$) taken in said decimation chain (14), and

a calibration unit (13) receiving said estimation (SE) of the power of a spurious tone (2th _spur) and configured to send a calibration signal ($DAC_{CAL}$) as function of said estimation (SE) of the power of a spurious tone to said digital to analog converter (113'), which comprises an output adjustment arrangement (115; 1131, 1132) configured to adjust an output signal ($DAC'_{out}$) of said internal digital to analog converter (113) based on said a calibration signal ($DAC_{CAL}$).

EP 4 787 714 A1

**Description**

Technical field

The description relates to an electronic conversion architecture comprising a Continuous Time Sigma Delta Analog to Digital Converter comprising a loop filter followed by an analog to digital converter and a feedback loop feeding back the output of said analog to digital converter through an internal digital to analog converter to obtain an error signal with respect to a input signal, which is fed to said loop filter, an output digital signal of the analog to digital converter being fed to a decimation chain of decimators, a local oscillator feeding a clock signal) to said analog to digital converter, and, through a frequency divider, to said chain of decimators.

One or more embodiments may be applied e.g. to radio system, such as wide band (e.g. 25 MHz) and dual tuner band (34 MHz) radios.

Technological background

Nowadays, the demands on the linearity of high- resolution D/A converters for measurement equipment and digital audio are so high that the achievable accuracy based upon matching of components in a standard process is not sufficient. Therefore, additional calibration techniques are used to achieve high resolution. A disadvantage of many calibration techniques is the need for a special calibration period. During this period, the converter cannot be used for conversion, which particularly limits the application range. Furthermore, a relatively large chip area is needed to store the error signals.

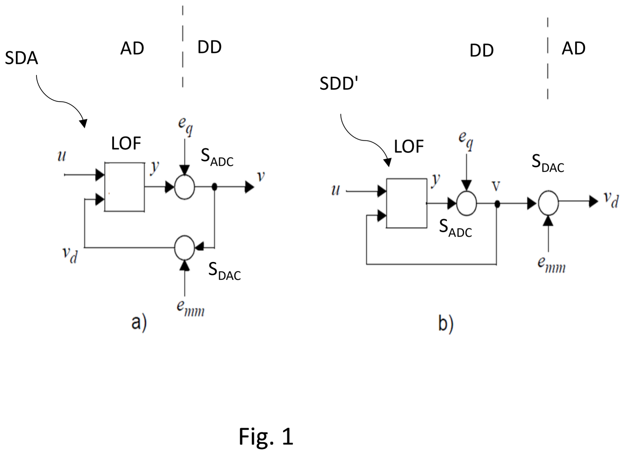

The DAC non-linearity is a key point in the design of DS A/D converters: in the Continuous Time Sigma Delta Analog to Digital Converters, such the SD ADC model SDA shown schematically in figure 1a, where DA and DD indicates the analog domain and digital domain of the signals, a DAC (block $S_{DAC}$) is internal to a feedback loop. As shown, a loop filter LOF receives the input analog signal u and a feedback analog signal vd, its filtered output y being converted in an output digital signal v with the introduction of a quantization error $e_q$ in the ADC conversion block $S_{ADC}$; the output digital signal v is fed back on the feedback loop comprising the DAC conversion, indicated by DAC block $S_{DAC}$, in which the mismatch error $e_{mm}$ is injected. The transfer function from the mismatch error $e_{mm}$ to the digital output $v$ is basically the same as the inherent signal transfer function. This filtering will not cancel the in-band mismatch noise. In the case of a SD DAC, SDD, which architecture is shown in figure 1b and correspond basically to that of figure 1A, with the DAC block $S_{DAC}$ placed at the output of the digital loop, the mismatch noise also remains unshaped.

For both cases in Figure 1a, 1b, there are in-band spurious tones, or spurs, caused by the DAC mismatch noise; the distortion mechanism remains the same. DAC induced out-of-band tones are filtered out by the post-filtering (decimation filter or an analog filter), but the in-band DAC-mismatch related noise will not be attenuated. To cancel the mismatch noise in the presence of imprecise component matching., the DAC mismatch noise can be attenuated with digital error correction or spectrally shaped with dynamic element matching (DEM).

Dynamic matching of unit-DAC elements refers to scrambling the usage of DAC elements so that the signal-dependent deterministic mismatch noise is transformed into a wide-band noise. A basic feature in all dynamic element matching (DEM) methods is that they do not reduce the error, instead the error is moved from the signal band.

Unlike DEM methods, digital error correction (DEC) cancels the mismatch noise instead of shaping the spectrum. In the concept of digital error correction, the element selection remains static. The correction is based on measuring the mismatches by the so-called calibration setup. Foreground calibration is a linearization method introduced at the end of the 80's in the last century.

Object and summary

An object of one or more embodiments is to contribute in dealing with a number of issues which are recognized to exist in a context as discussed in the foregoing.

According to one or more embodiments that object may be achieved by means of a converter architecture having the features set forth in the claims that follow.

One or more embodiments may relate to a corresponding method for calibrating a converter architecture.

As mentioned previously, various embodiments of the present disclosure regard a conversion architecture comprising a Continuous Time Sigma Delta Analog to Digital Converter comprising a loop filter followed by an analog to digital converter and a feedback loop feeding back the output of said analog to digital converter through an internal digital to analog converter to obtain an error signal (e) with respect to a input signal, which is fed to said loop filter, an output digital signal of the analog to digital converter being fed to a decimation chain of decimators, a local oscillator feeding a clock signal to said analog to digital converter, and, through a frequency divider, to said chain of decimators, wherein said conversion architecture further comprises

a circuit arrangement configured to obtain a calibration tone by a divided frequency outputted by said frequency divider to said chain of decimators and inject said calibration tone in said feedback loop, in particular in the input path of said analog to digital converter, a calibration arrangement which comprises

a spurious tone estimation module configured to obtain an estimation of the power of a spurious tone in said output signal based on a decimated signal taken in said decimation chain, and

a calibration unit receiving said estimation of the power of a spurious tone and configured to send a calibration signal as function of said estimation of the power of a spurious tone to said digital to analog converter, which comprises an output adjustment arrangement configured to adjust an output signal of said internal digital to analog converter based on said a calibration signal.

In variant embodiments, said spur estimation module comprises a filter configured to filter around a selected spur to which output is coupled a module configured to calculate a FFT power spectrum of said selected spur, to which output is coupled a module configured to calculate spur estimation as a maximum amplitude of said FFT power spectrum.

In variant embodiments, said calibration unit comprises a sequencer module which receives said spur estimation, said sequencer module one or more sequence of correction values to be fed to a DAC level control module configured to issue a corresponding calibration signal to said output adjustment arrangement configured to adjust an output signal of said internal digital to analog converter based on said a calibration signal.

In variant embodiments, said internal digital to analog converter comprises an arrangement of back-gated MOSFET determining the output of said internal digital to analog converter based on the output digital signal at its input, said output adjustment arrangement being configured to send said calibration signal to the back gates of said back-gated MOSFET to modify their transconductance.

The solution described herein also refers to a calibration method of the conversion architecture according to embodiments, comprising

- generating a calibration tone with an out-of-band frequency, compared to a baseband signal of said conversion architecture,
- injecting said calibration tone in the input path of the analog to digital converter;
- taking the analog to digital converter output signal;
- estimating the power of a spurious tone selected in the taken output signal;
- on the basis on the estimated power value, adjusting the output levels of the DAC with a calibration signal to minimize said estimated power value.

In variant embodiments, the operation of, on the basis on the estimated power value, adjusting the output levels of the DAC with a calibration signal to minimize said estimated power value comprises performing a level correction procedure comprising the steps of:

for each of the output levels of the DAC output signal of the DAC applying a sequence of increasing correction values of calibrated voltage correction to DAC output levels,

measuring for each applied correction value the estimated power of the estimated spur and storing it in a measurement array,

at the end of said sequence of increasing correction values finding in said measurement array the measured power of the estimated spur with the minimum value, select the corresponding correction value as calibration value in the calibration signal applied during the conversion operation to set said output level of the DAC output signal.

In variant embodiments, the method comprises selecting an order value and performing subsequent iterations of said calibration signal level correction procedure, updating at the end of each iteration for each level the calibration value in the calibration signal level correction procedure and decreasing the order value, till the order value reaches a threshold at which iterations are stopped and the current calibration value is selected as calibration value in the calibration signal applied during the conversion operation to set said output level of the DAC output signal.

In variant embodiments, the length of said sequence of increasing correction values and a voltage difference between each pair of correction values being proportional to said order value.

In variant embodiments, said decreasing includes dividing by two said order value.

The claims are an integral part of the technical disclosure of the embodiments as provided herein.

Brief description of the several views in the drawings

One or more embodiments will now be described, by way of example only, with reference to the annexed figures, wherein:

- Figures 1 and 2 have been already described in the foregoing.,
- Figure 3 is a schematic block diagram of a conversion architecture according to embodiments,
- Figure 4 is a schematic block diagram of a conversion architecture according to embodiments showing further details,
- Figure 5 is a schematic block diagram detailing a module of the architecture of figure 3;
- Figure 6 is a diagram of correction values applied by a calibration method of the conversion architecture according to embodiments;
- Figure 7 and 8 are diagrams representing correction values applied by a calibration method of the conversion architecture according to embodiments in different iterations,
- Figure 9 is a circuit diagram of an embodiment of an analog to digital converter operating in the conversion architecture according to embodiments;
- Figure 10 is a block diagram of a portion of the conversion architecture according to embodiments comprising the analog to digital converter of figure 9;
- Figure 11 is circuit diagram of a portion of the conversion architecture according to embodiments comprising a further embodiment of analog to digital converter.

Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The references used herein are provided merely for convenience and hence do not define the extent of protection or the scope of the embodiments.

Here, a self-calibration technique for a conversion architecture with a Sigma Delta converter, in particular for the digital to analog converter, DAC, inside the Sigma Delta Analog to Digital Converter, SD ADC, is described, in which during the calibration period the Sigma Delta converter can be operated on the input signal. Moreover, the conversion architecture and the corresponding method are adaptive to process/temperature variations. The technique is implemented in a standard CMOS process, which is also the best process choice for low power consumption.

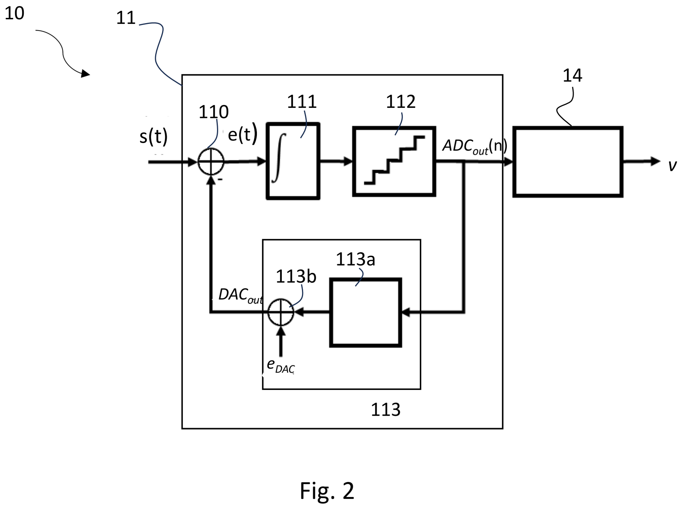

Figure 2 below shows a continuous time Sigma Delta ADC (CTSD-ADC), comprising., as described below, a non-ideal DAC with mismatches in its output levels, for instance due to differences in the component implementing the conversion.

In Figure 2 thus with the numerical reference 10 is indicated an electronic circuit architecture comprising a Continuous Time Sigma Delta Analog to Digital Converter, in the following CTSD-ADC, 11, which outputs an output digital signal $ADC_{out}$ which is filtered by a decimation block, 14, which is implemented by a chain of one or more decimators, outputting a digital output decimated signal. The decimator basically implements a down-sampling of its input signal, keeping one out of a number of samples depending on its driving frequency.

The CTSD-ADC 11 comprises an analog-to-digital converter, i.e., ADC, 112, which digital output $ADC_{out}(n)$, where n is the number of bits of the digital signal, is fed back through a digital-to-analog converter, i.e., DAC, 113, as DAC analog output signal $DAC_{out}$, to a difference block 110 calculating an error e(t) between an analog input signal s(t), i.e. varying in time t, and an analog feedback signal corresponding to the analog output signal $DAC_{out}$ of the DAC 113. Such error e(t) is fed as input to the loop filter 111. The DAC 113, as shown, is not-ideal, i.e. contains mismatches, thus it is schematized with an ideal DAC 113a receiving the output digital signal $ADC_{out}$ and to which analog ideal output in a summation block 113b is added a DAC error, $e_{DAC}$, substantially corresponding to the mismatch error $e_{mm}$ of figure 1a, to obtain the DAC analog output signal DAC. The ADC 112 usually receives a clock signal for its operation, which is sent by an oscillator, e.g. a PLL (Phase Locked Loop), here not shown, which clock signal is also used, usually frequency divided in one or more divided clock signals by a divider circuit, by the decimator 14, in particular decimator chain.

The Inventors have observed that if a calibration tone is inserted in the loop so that enters the input of the ADC 11 with a proper power level, i.e., compatible with the ADC operation like below saturation level, the mismatches of DAC 113 generate significant spur tones at multiples of the frequency of the calibration tone. Starting from this consideration, the solution provides a conversion architecture comprising a SD ADC and a calibration system which, using a measurement of such spurs, generates calibration signals, e.g. currents/voltages, in the DAC 113 to reduce the mismatches of DAC 113 itself, making a reduction of spurs power level.

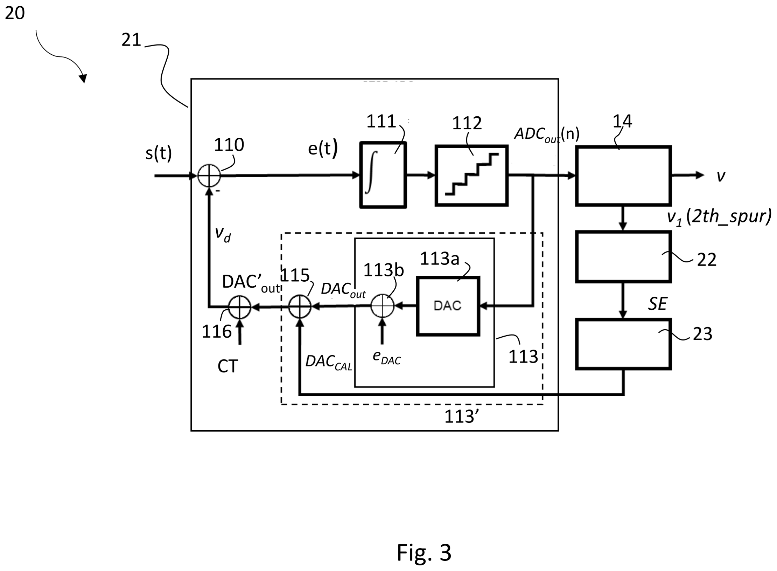

As shown in figure 3, where same numeric references indicate same components as in the previous figures, an electronic conversion architecture 20 corresponds substantially to the architecture 10 of figure 2, but, in the first place, it further comprises a summation block 116 which receives a calibration tone CT and which is inserted in the feedback loop, i.e., receives the analog output signal DAC'$_{out}$ of a digital to analog converter 113' and the calibration tone CT, outputting an analog signal vd, in particular supplied to the difference block 110, which is the sum of the analog output signal DAC'$_{out}$ and of the calibration tone CT, i.e., inserts the calibration tone CT. The conversion architecture 20 also comprises a spur estimation block 22, which takes a decimated signal v1, in the exemplary embodiment the first decimated signal in the decimator chain, as better explained below, from the decimator 14 and it is configured to measure a given spur, *2th_spur,* in such decimated signal $v_1$, i.e., provide a spur power estimation SE, i.e., an estimation of the power of the spurious signal, and a subsequent calibration block 23, which is configured to generate a calibration signal DAC$_{cal}$, e.g. currents/voltages, to control and correct the output levels of the non-ideal DAC 113. This is represented by a summation block 115 which receives the analog output DAC$_{out}$ of the DAC 113 and sums it with the calibration signal DAC$_{cal}$, providing its output, a mismatch compensated analog output DAC'$_{out}$ to the summation block 116 to be summed with the calibration tone CT, the resulting sum being fed to the block 110 to obtain the error e(t).

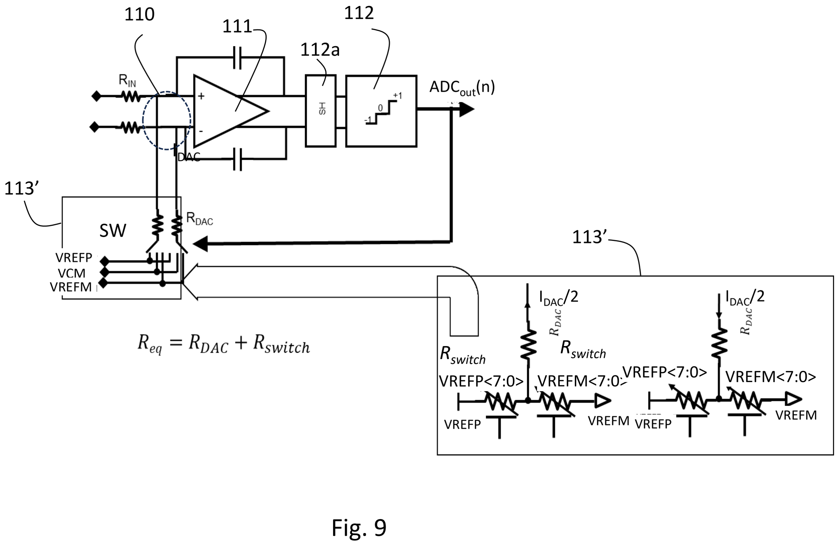

To this regard it is pointed out that the calibration signal DAC$_{cal}$ in figure 3 is represented as a correction summed to the output DAC$_{out}$ of the not-ideal DAC 113, i.e., if the output DAC$_{out}$ is represented by a set of voltage values or current values, depending on the type of DAC, the calibration signal DAC$_{cal}$ may comprise corresponding voltages or currents with correction values to be summed to the voltage or current values of the output DAC$_{out}$ to compensate for the mismatches. However, as explained further in the description, the correction can be performed preferably by using the calibration signal DAC$_{cal}$ to modify the voltage or current values of the output DAC$_{out}$ operating on the DAC 113 circuit arrangement. Thus, as shown in figure 3, the architecture 10 comprises a compensated DAC 113', which includes the DAC 113 and the summation block 116, which is representative of applying the calibration signal DAC$_{cal}$ to the DAC 113 to adjust the voltage or current values of the output DAC$_{out}$ either by compensating directly such output DAC$_{out}$, i.e., by summing or subtracting the calibration signal to the output value, other operations of mixing at the output of the DAC 113 between the output DAC$_{out}$ and the calibration signal DAC$_{cal}$ being not excluded, or by controlling the voltage or current values outputted by the DAC 113 adjusting the operation of internal components of the DAC 113, as shown in figures 9 to 11.

The solution therefore proposes a method to calibrate the architecture described, i.e., estimate and correct DAC mismatches in real time, injecting a tone, i.e., the calibration tone CT, onto the non-ideal DAC 113 output, where the calibration tone CT is taken for example from the decimation chain 14, or also from a separate source.

Then, the method provides to:

- generate a calibration tone CT with an out-of-band frequency (e.g. ~46Mhz), compared to the baseband signal (e.g. 17MHz) of the system, i.e., the input signal s(t) to the converter 20';
- inject the calibration tone CT onto the ADC 112 input to enhance the nonlinearities of the DAC 113 avoiding any impact on the base-band signal;
- take a version of the ADC 112 output signal ADC$_{out}$ (e.g. first decimator signal $v_l$). For version it is here intended the output signal ADC$_{out}$ itself or a signal obtained by it, e.g. applying a decimation. This signal is function of the frequency of the harmonic it is desired to attenuate;
- estimate the power SE of the spurious signal 2TH_SPUR in the taken output signal, e.g. $v_1$ (using the spur estimator block 22);
- depending on the estimated power SE, act with the Calibration Unit block 23 by compensating the output levels DAC$_{out}$ with a calibration signal DAC$_{cal}$. This is in figure 3 is represented by a sum 116 at the output of DAC 113, as mentioned however this is an equivalent abstract representation, the compensation being in embodiment performed of the on the internal DAC 113a parameters by regulating its internal references (resistances or current thresholds) to minimize the estimated power SE in real time and correct the DAC mismatch.

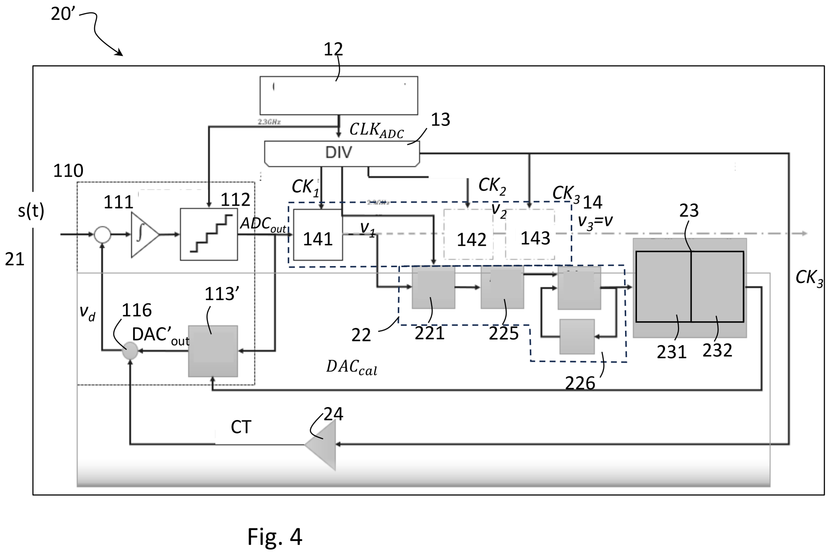

In Figure 4 it is shown an embodiment 20' of the architecture 20 of figure 3, in which the Continuous Time Sigma Delta Analog to Digital Converter 11 is shown receiving an ADC clock signal CLK$_{ADC}$ with a frequency f$_{CLK}$ from a local oscillator 12, e.g., a PLL oscillator. The output *ADC$_{out}$* of the CTSD-ADC 11 is filtered by the decimation block, 14, which is implemented by a chain of decimators. In the example shown such chain of decimators comprises three decimators in sequence 142, 142, 143. Each decimator 141, 142, 143 is driven by a respective decimator clock signal CK1, CK2, CK3 with respective frequency f$_{CLK}$/K1, f$_{CLK}$/K1K2 f$_{CLK}$/K1K2K3, K1, K2, K3 being constant values, obtained by a divider 13 which receives the ADC clock signal CLK$_{ADC}$ and divides its clock frequency respectively by K1, K1*K2, K1*K2*K3, i.e., each decimator has a frequency which is a submultiple of that of the preceding decimator. The first decimator 141 outputs a first decimated output signal, $v_1$, which corresponds to the output ADC$_{out}$ decimated, i.e., down-sampled with the first divided frequency f$_{CLK}$/K1. A second decimated signal $v_2$ and third decimated signal $v_3$, which is the output of the decimation chain 14, are then obtained analogously from the second and third decimator 142 and 143 in series with the first decimator 141 and driven by the respective second and third divided frequency $f_{CLK}$/K1K2 and $f_{CLK}$/K1K2K3.

In figure 4 the divided clock CK3 is inserted in the path before the input of the ADC 11, namely before the error (e(t)) calculation, e.g. in module 110, with a proper power level, e.g., a level that is below the saturation maximum voltage of the ADC integrators, set through an amplifier 24, so that the mismatches of DAC 113 generate significant spur tones at multiples of the decimator clock CK3 with respective frequency $f_{CLK}$/K1K2K3.

By way of example $f_{CLK}$ is 2.3 GHz, $f_{CLK}$/K1=2.3 GHz/5=466 MHz, $f_{CLK}$/K1K2=2.3 GHz/25=92 MHz, $f_{CLK}$/K1K2K3=2.3 GHz/50=46 MHz.

It is also detailed the spur estimation block 22 which receives as input from the decimator 14 the first decimated signal $v_1$, which is further input to a CIC (Cascade Integrator Comb) decimator 221, which receives a divided frequency $f_{CLK}$/K4, in the example equal to $f_{CLK}$/10, i.e. 233 MHz. It is also shown a FFT squarer block 225 which is preceded by a band pass filter, not shown here, centered around the frequency $f_{2th\_spur}$ of the spur 2TH_SPUR received by the decimator 221 in the first decimated signal $v_1$. A power estimator 226 receives the output of a power spectrum calculation block 225, configured to calculate a power spectrum SSF2 of the spur 2TH_SPUR, and computes a spur estimation value SE, i.e., calculates the maximum amplitude of the power spectrum SSF2. The spur estimation SE is sent to the calibration unit 23, which comprises a sequencer 231, followed by a DAC level control module 232 issuing the calibration signal $DAC_{CAL}$, i.e. a set of currents and/or voltages which values change the output levels of the calibrated DAC 113', which is indeed shown here as a whole block or module, producing the compensated output signal $DAC_{out}$.

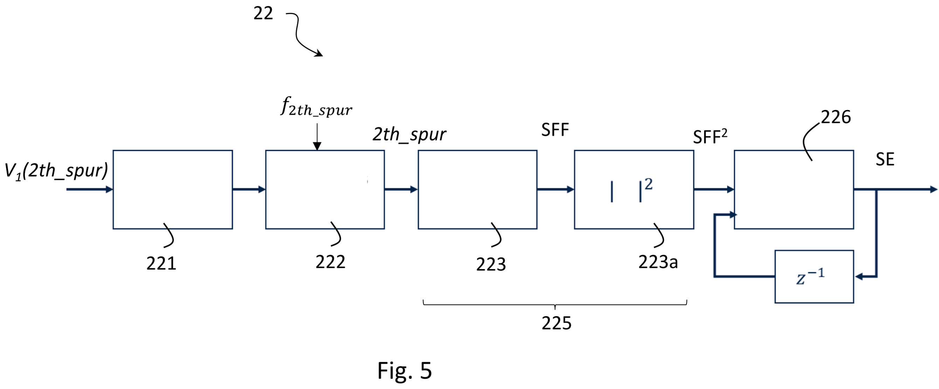

In figure 5 it is shown an embodiment of the spur estimator 22, which comprises a band pass 222 filter, e.g. a discrete FIR filter, centered around the frequency $f_{2th\_spur}$ of the spurious tone or spur 2TH_SPUR received by the first decimator 141 in the taken signal, in the example first decimated signal $v_1$, and a FFT block 223 configured to perform a Fast Fourier Transform of the filtered spurious tone, then the output FFT signal SFF is fed to a square calculation circuit 223 which calculates the squared FFT, $SFF^2$, of the spectrum SFF, substantially the power spectrum of the filtered spurious tone 2th_spur at frequency $f_{2th\_spur}$. of the FFT, followed by a power estimator 226, supplying the spur estimation SE. Blocks 223 and 223a correspond to the FFT power spectrum block 225. The CIC (Cascade Integrator Comb) decimator 221 is inserted, as in the example shown, before the band pass filter 222, to improve the estimate. It is noted that decimator 221 may be optional.

Substantially, the signal taken from the decimator 14, in the example first the decimated signal $v_1$, is filtered around the selected spur, e.g. the second spur, then the FFT blocks 223, 223a, corresponding together to block 225, obtain the FFT power spectrum $SFF^2$ of the spur 2th_spur, in particular the FFT squared, then the maximum amplitude of the FFT power spectrum $SFF^2$ is calculated in the power estimator 22, which is configured to find the maximum amplitude of such power FFT power spectrum $SFF^2$, in particular by computing its absolute value which is compared with the previous maximum value by a delay line.

Thus, based on the above, the solution described is directed to a conversion architecture, e.g., 20, 20' comprising a Continuous Time Sigma Delta Analog to Digital Converter, e.g., 11 comprising a loop filter, e.g., 111 followed by an analog to digital converter, e.g., 112 and a feedback loop, e.g., specifically a calibrated converter feeding back the output, e.g., output signal v or $ADC_{out}$, of said analog to digital converter, e.g., 112 through an internal digital to analog converter, e.g. 113' to obtain , e.g., by the differenc block 110, an error signal , e.g., e(t), with respect to a input signal, e.g., *u, s (t),* which is fed to said loop filter, e.g., 111, an output digital signal, e.g., $ADC_{out}$ of the analog to digital converter, e.g., 112 being fed to a decimation chain of decimators, e.g., 14, a local oscillator, e.g., 12 feeding a clock signal , e.g., $CLK_{ADC}$ to said analog to digital converter, e.g., 112, and, through a frequency divider, e.g., 13, to said chain of decimators, e.g., 14, wherein said conversion architecture, e.g., 10 further comprises

a circuit arrangement, e.g., configured to obtain, e.g. through the amplifier 24 setting the level, a calibration tone, e.g., CT by a divided frequency, e.g., CK3 outputted by said frequency divider, e.g., 13, to said chain of decimators, e.g., 14 and inject said calibration tone, e.g., CT in said feedback loop, e.g., in the sum block 116, in particular in the input path of said analog to digital converter, e.g., 112, this meaning that it could be also injected downstream the sum block 110 for instance,
a calibration arrangement, e.g., 22, 23 which comprises

a spurious tone estimation module, e.g., module 22, configured to obtain an estimation, e.g., SE of the power of a spurious tone, e.g., *2th_spur* in said output signal, e.g., v based on a decimated signal, e.g., $v_1$ taken in said decimation chain, e.g., 14, and
a calibration unit, e.g., 13 receiving said estimation, e.g., SE of the power of a spurious tone, e.g., *2th_spur* and configured to send a calibration signal, e.g., $DAC_{CAL}$ as function of said estimation, e.g., SE of the power of a spurious tone to said digital to analog converter, e.g., 113', which comprises an output adjustment arrangement, e.g., 115; 1131, 1132 configured to adjust an output signal, e.g., $DAC'_{out}$ of said internal digital to analog converter, e.g., 113 based on said a calibration signal, e.g., $DAC_{CAL}$.

The choice of the calibration tone CT must be made so that it falls outside the system band or base band, e.g., the frequency of the input signal which the SD-ADC converter can handle. In the example here shown it is 17 MHz. For example, a possible choice is a tone at the sampling frequency of the last decimator 143, as shown in figure 4, i.e., $f_{CLK}$/K1K2K3=2.3 GHz/50=46 MHz. It is important that the calibration tone CT has a high purity, for this reason the choice of the example takes the signal of the VCO of the PLL of the local oscillator 12, through the divider 13. The spur chosen for calibration must be the second or at most the third in frequency among those generated.

Now the operation of the calibration unit 23 is described.

Considering a DAC 113 whose analog output levels, e.g., voltage output levels, are a set of levels [0 ... $N_{levels}$] with $N_{levels}$ + 1 being the number of output analog levels of such DAC 113, $N_{evels}$+1=2$^{Nbit}$, Nbit being the number of input bits of the DAC 113, to such output levels [0 ... $N_{levels}$] corresponds a vector $DAC_{ideal\_out}$ of ideal output voltages of the DAC 113,

$$DAC_{ideal\_out} = -V_{ref}: V_{step}: V_{ref}$$

where a voltage step, i.e. the step of the DAC 113, is defined as $V_{step} = \frac{2V_{ref}}{N_{levels}}$ and $V_{ref}$ is a reference voltage of the DAC 113.

Due to the mismatches, the voltage levels of the vector $DAC_{ideal\_out}$ present an error that it can be considered distributed in a Gaussian way and whose standard deviation is equal to a percentage $lp_{mis}$ of the value of the step $V_{step}$.

Thus, the actual output of the DAC 113 $DAC_{out}$ can be indicated as:

$$DAC_{out} = DAC_{ideal_{out}} + lp_{mis}V_{step} \cdot randn$$

*randn* indicating a random value.

It can be assumed that the error of one level among the DAC output levels [0 ... $N_{levels}$] is independent of the adjacent ones.

The calibration unit 23 does not know and cannot directly measure the values of the actual output of the DAC 113 $DAC_{out}$.

As the only measure of the effect of the calibration, is available the spur estimation SE, i.e., the measurement of the power of the second spur tone, called $f_{2th\_spur}$, determined by the calibration tone CT, which is injected in the feedback path and thus manifest itself in the output of the ADC, $ADC_{out}$, which is brought to the spur estimator 22 from the decimator 14, in the example the first decimated output signal, $v_1$, is taken. For this reason the frequency of the second spur $f_{2th\_spur}$ is double the frequency of the calibration tone CT.

The aim of the calibration unit 23 is to find a DAC calibration signal $DAC_{CAL}$ such that the sum $DAC_{out}$ + $DAC_{cal}$ minimizes the power level of the second spur tone $f_{2th\_spur}$.

The procedure described below, implemented by the calibration unit 23, establishes the sub-optimal DAC calibration $DAC_{CAL}$ values, outputted by the calibration unit 23, level by level. This calibration procedure is repeated several times, called calibration iterations, until there is no longer an improvement in the mismatch level.

Substantially, a calibration method of the architecture 20 or 20' comprise a calibration value calculation procedure in which, for each of the DAC output levels, e.g. $N_{level}$+1 DAC output levels, of the output signal $DAC_{OUT}$, comprises

applying a sequence of increasing test values of calibrated voltage or current corrections to the corresponding DAC output voltage or current (r),

measuring for each test value of calibrated voltage correction which is applied a power of the estimated spur SE and storing it in a measure array, M,

at the end of said sequence finding in said measure array M the measured power of the estimated spur SE with the minimum value,

select the corresponding test value of calibration voltage correction as calibration value in the calibration signal $DAC_{cal}$ corresponding to said analog output level.

The method provides then an iterative refinement procedure comprising

setting an order value *Order,* a number of iterations performed by the iterative refinement procedure being function of said order value, performing subsequent iterations of said calibration value calculation procedure, updating at the end of each iteration for each level the calibration value in the calibration signal $DAC_{CAL}$ and decreasing the order value *Order,* till the order value *Order* reaches a threshold at which iterations are stopped and the current calibration values in the calibration signal $DAC_{CAL}$ maintained, the length of said sequence and a voltage difference $step_{cal}$ between each pair of test values of calibrated voltage correction in the sequence being proportional to said order value *Order.* In particular, said decreasing the order value *Order* includes dividing by two said order value *Order.*

Thus, at each calibration iteration, a calibration unit 23 sequencer, which implements the algorithm, starting from the first level of the actual DAC output $DAC_{out}$, applies the correction currents/voltages in the calibration signal to the DAC 113 output following the equations below:

$$max_{voltage_{ctrl}} \geq 3lp_{mis}V_{step}$$

A maximum voltage $max_{voltage_{ctrl}}$, which corresponds to the range of voltage correction values for the calibration is set as greater equal than three time $lp_{mis}V_{step}$, which is three time the standard deviation of the output levels of the DAC output signal $DAC_{out}$, i.e. the known 3σ criterion, times the output voltage step $V_{step}$ of the output of the DAC 113, which, as mentioned, depends on the number of output levels $N_{level}+1$, and the reference voltage $V_{ref}$.

Then an initial calibration step $step_{cal}$ is calculated as:

$$step_{cal} = \frac{max_{voltage_{ctrl}}}{max\left(\frac{order_{cal}-1}{2}, 2\right)} \tag{1}$$

i.e., the calibration step $step_{cal}$ is the ratio of the maximum voltage $max_{voltage_{ctrl}}$, i.e., the calibration range, divided by the maximum between 2 and the half of the calibration order $Order_{cal}$ minus one. Since the maximum voltage $max_{voltage_{ctrl}}$ is $\geq 3lp_{mis}V_{step}$, thus the value of the calibration step $step_{cal}$ is half the maximum voltage $max_{voltage_{ctrl}}$ or lower, depending on the calibration order $Order_{cal}$ value, i.e., proportional to the standard deviation $lp_{mis}*V_{step}$, specifically 3/2 or lower depending on the calibration order $Order_{cal}$ value.

Equation (1) sets the initial value of the calibration step $step_{cal}$, which however is divided then in the example by three at the end of each calibration step when the value of the calibration order $Order_{cal}$ is instead halved, as shown in the example of the Sequencer algorithm below. As indicated there the value of the calibration step or $step_{cal}$ or step and of the order $Order_{cal}$ or Order are updated each time the algorithm is performed on the whole set of levels, i.e., as explained below, for each output level 1 from 0 to $N_{level}$, with a given value of order *Order* and step Step, a procedure is performed, which, as detailed in the Sequencer routine below, for each level applies the correction for the mismatch, measuring then the power of the spur tone SE is measured, and finding the minimum absolute value of the measure array M(t) and its index stored as minimum value min_val and minimum index min_index, then changing the correction table Corr_table for t=min_index with the minimum value min_val, i.e., the correction value in the sequence $Steps_{Table}$ which determines the minimum value of the power of the spur.

A sequence $Steps_{table}$ of correction values for a given output level of the DAC output signal is then:

$$Steps_{table} = \begin{bmatrix} \dfrac{-(Order_{cal}-1)}{2}step_{cal} \\ step_{cal} \cdot ones\left(1, \dfrac{(Order_{cal}-1)}{2}-1\right) \\ 2step_{cal} \\ step_{cal} \cdot ones\left(1, \dfrac{(Order_{cal}-1)}{2}-1\right) \\ \dfrac{-(Order_{cal}-1)}{2}step_{cal} \end{bmatrix}$$

$$\tag{2}$$

i.e., the sequence ranges from $\frac{-(Order_{cal}-1)}{2}step_{cal}$ to $\frac{(Order_{cal}-1)}{2}step_{cal}$ increasing of calibration step $step_{cal}$ at each subsequent correction value in the sequence, skipping the zero correction value, i.e., the sequence passes from a correction of $+step_{cal}$ to a correction of $-step_{cal}$. The last correction value $\frac{-(Order_{cal}-1)}{2}step_{cal}$ has the minus sign, since it is the correction value which measures at the center point, i.e. zero correction value, which was skipped. Such center, which corresponds to the actual level of the DAC output $DAC_{out}$ is thus the last measure.

In equation (2) the sequence of correction values is shown as transposed vector, i.e. a column, for space reasons, but it can be regarded also an array, i.e. an array of a row representing the sequence of correction values.

This sequence $Step_{stable}$ of correction values is applied for a specific level among the Nlevel+1 output levels of the DAC 113 and for a specific calibration order $Order_{cal}$ value. The length of the sequence $Steps_{table}$ depends on the value of the calibration order $Order_{cal}$ value, in particular is equal to the calibration order $Order_{cal}$ value.

Then a correction table $Corr_{table}$ is obtained as sum of the sequences $Step_{stable}$ for each of the $N_{levels}$+1 output level of the DAC 113 as a sum over the number of output $N_{levels}$ and refined a number of times defined by the calibration order $Order_{cal}$,

$$Corr_{table} = \{\textstyle\sum_{k=0}^{n} Step_{table}(k)\}_{n=0:Order_{cal}} \tag{3}$$

$Step_{table}(k)$ is the k-th element, i.e. the k-th test correction value in the sequence $Step_{stable}$. Thus a correction table $Corr_{table}$ for a given output level of the DAC 113 is a set of summations of correction sequences $Steps_{table}$ with n+1 correction values, where n is set by the calibration order $Order_{cal}$ value, i.e., is the sum of sequences correction sequences $Step_{stable}$ of different lengths depending on the calibration order $Order_{cal}$ value as said. The correction table $Corr_{table}$ depends on the calibration order $Order_{cal}$ value, but the calibration order $Order_{cal}$ value during the iterations loop decrease because at each iteration is divided by two

The Calibration Order, $Order_{cal}$ is the number of voltage or current test points of test points, i.e., number of measures, around a DAC 113 level. Thus, the time to calibrate a single level is hereafter called Level Time Calibration (LTC).

Generally, at the first calibration iteration the Calibration Order $Order_{cal}$ is set as an odd number greater than 15. At subsequent calibration iterations, the Calibration Order $Order_{cal}$ is halved and as consequence the calibration step $step_{cal}$ is also reduced.

Thus, the calibration method, performing the corrections of the DAC mismatch errors, of the conversion architecture, e.g. 20, 20', may be summarized as comprising the steps of:

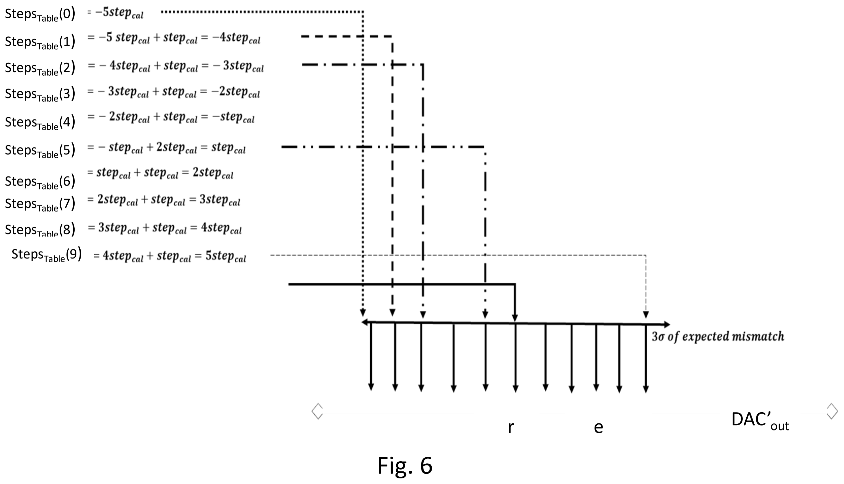

- generating - e.g. by taking a clock signal, e.g. CK3, with a divided frequency with respect to that of the oscillator, e.g., 12, feeding its clock signal $CLK_{ADC}$, to the ADC 112 - a calibration tone, CT, with an out-of-band frequency, compared to a baseband signal of said conversion architecture e.g. 20, 20',
- injecting such calibration tone CT in the input path, e.g., downstream the calibrated ADC 113, of the analog to digital converter 112;
- taking a version of the analog to digital converter 112 output signal, in the example a decimated version $v_1$ of it;
- estimating., by the estimator module 22, the power, e.g. the estimation SE, of a spurious tone, in the example the second spur 2th-spur although other spurs may be chosen, selected in the taken version of the output signal, e.g., $v_1$;
- on the basis on the estimated power, e.g., SE, value, adjusting., by the calibration unit 23, the output levels, e.g. the levels of the analog output signal DAC'$_{out}$ of the calibrated DAC 113', with a calibration signal DAC$_{cal}$, to minimize said estimated power SE value, e.g., by the exemplary procedure performed by the sequencer 231 described with the pseudo-codes below and figures 6 to 8.

An example of procedure performed by the sequencer 231, named Sequencer, along with its sub-procedures or sub-routines, new_Corr_table, apply_change, measure_2LO_tone are resumed below in a pseudocode.

The main procedure Sequencer determines the correction table $Corr_{table}$ receiving as input the calibration order Order, an odd integer, the number of input bits Nbit of the DAC 113. Also the procedure Sequencer receives time values for correct operation, a hold time Thold, i.e. a time to wait for the settling of the system after applying a correction, and a measure time Tmeasure, i.e., a duration of the measure of the spur power in the module 22. Thus, as an example, the corresponding pseudocode may be:

Sequencer

**input** :Order (odd integer), Step (the initial step voltage) $N_{bit}$ (bit of DAC level control),
Thold (Hold time), Tmeasure (measure Time)

---

$Corr_{table} \leftarrow$ new_Corr_table(Order, $N_{bit}$)
**while** Order>=2 **do**
    **for** l=0 **to** Nlevel **do**

$$MT \leftarrow 0$$

**for** t=0 **to** Order **do**

    corr_word $\leftarrow Corr_{table}(t)$

    apply_change(l,corr_word,Thold)

    $MT(t) \leftarrow$ measure_2LO_tone(Tmeasure)

  **end for**

  min_val, min_index $\leftarrow$ min(abs($MT$))

  apply_change(l,$Corr_{table}$(min_index),Thold)

**end for**

Order $\leftarrow$ Order/2

Step $\leftarrow$ Step/3

$Corr_{table} \leftarrow$ new_Corr_table(Order, Step, $N_{bit}$)

**end while**

The sub-routine new_Corr_Table, which receives as input within the procedure Sequencer the calibration order Order, an odd integer, the number of input bits Nbit and outputs the correction table Corr$_{table}$, corresponds to apply equations (1), (2), (3) above:

new_Corr_table

**input** : $Order_{cal}$ (odd integer), $step_{cal}$(the voltage step), $N_{bit}$ (number of bits of DAC level control)

**output** : $Corr_{table}$

$$Steps_{table} = \begin{bmatrix} \dfrac{-(Order_{cal}-1)}{2}step_{cal} \\ step_{cal} \cdot ones\left(1,\dfrac{(Order_{cal}-1)}{2}-1\right) \\ 2step_{cal} \\ step_{cal} \cdot ones\left(1,\dfrac{(Order_{cal}-1)}{2}-1\right) \\ \dfrac{-(Order_{cal}-1)}{2}step_{cal} \end{bmatrix}$$

$$Corr_{table} \leftarrow \left\{\sum_{k=0}^{n} Step_{table}(k)\right\}_{n=0:Order}$$

---------------------------------------------

The subroutine apply_change receives as input the current level 1 among the output levels of the DAC 113, which is set by the procedure Sequencer, a correction word variable Corr_word also set by the procedure Sequencer (corresponding to the correction table $Corr_{Table}$ at a current value of the calibration order Order), and also the hold time Thold.

The corresponding exemplary pseudocode is:

apply_change

**input** :level, Corr_word, Thold

DAC_register(level) ←Corr_word

Wait(Thold)

Then, the spur measurement sub-routine measure_2LO_tone, just measures the power SE of the spurious signal in the taken output signal, e.g. $v_l$, by the estimator block 22, thus is:

measure_2LO_tone

**input** :Tmeasure

**output**: measure

Wait(Tmeasure)

measure ← Max output values

Thus, in the routine Sequencer performed by the module 23, the following procedure is performed while the calibration Order is greater equal than two. As a first step the correction table Corr$_{table}$ is set as array or matrix, using the sub-routine new_Corr_table which calculates equations (1), (2), (3), which as shown are function of the calibration order Order and of the number of bit Nbit, corresponding to n and outputs the correction table Corr$_{table}$. Thus, a series of sequences Steps$_{table}$ of correction values proportional to the calibration step Stepcal (with the exception of the zero correction) where the length of each sequence Step$_{stable}$ and number of sequences in the series, i.e., correction table Corr$_{table}$, depends from the calibration order Order, is stored. As said the length of a sequence Steps$_{table}$ corresponds to the value of the calibration Order, while the number of sequences depends, if the calibration order Order, on how many subsequent operations round_odd (Order/2), i.e., rounding to the nearest odd integer the order Order halved by two are required to reach zero. For instance Order = 25 means 5 sequences, i.e., iterations, while Order = 15 means for 4 iterations.

Then for each output level 1 from 0 to N$_{level}$ a procedure is performed, in which a mismatch measure array MT is set to zero, then for each sequence index value t between zero and the current calibration order Order is performed in which in the correction word corr_word, i.e., the current correction value for the current value of the sequence index value t (also indicated with k elsewhere) is stored in an array DAC_register with an index corresponding to the level 1. The value is stored in the register array DAC_register is representative of the correction being applied by the DAC 113' for that level 1 in its output signal DAC'$_{out}$. The change applying sub-routine apply_change is performed, i.e., a correction for the mismatch is applied to level 1. Then the hold time Thold is waited, long enough to allow the corrections to propagate through the loop, through blocks 111, 112, to the output ADC$_{out}$, then the power of the spur tone, i.e. second spur tone, SE is measured, at the estimator 22, for the duration of the measure time Tmeasure. Then its value is stored in the measure array M(t), t being the index of the correction value in the sequence Steps$_{Table}$ for the current level 1. When the correction values from zero to order Order have been all applied and the measure array M(t) filled with the corresponding measured values of the spur SE, the minimum absolute value of the measure array M(t) and the value of index t in the array are stored as minimum value min_val and minimum index min_index. Subsequently the change application procedure apply_change is applied with the current output level 1 and the correction table Corr_table for t=min_index, i.e., the correction value in the sequence Steps$_{Table}$ which determines the minimum value of the power of the spur.

The steps of the spur minimization procedure are repeated for each of the analog output levels 1 from 0 to N$_{level}$. At the end of the repetitions on all the levels 1, the order value Order is halved (and rounded to the greatest odd integer) and the correction table Corr$_{table}$ is again set as array or matrix, using the sub-routine new_Corr_table with the new, halved, valued of calibration order Order and the number of bit Nbit, which is unchanged, storing it in the correction word corr_word.

As mentioned the whole procedure is performed, till the value of the calibration order value Order is greater equal than two.

Thus, during a Level Time Calibration LTC, for each step of modified voltage/current in the DAC 113, the maximum RMS power of the tone $f_{2th\_spur}$ is measured and this value is stored in a memory (e.g., array M(t)). At the end of the time LTC, when all the steps of the tests for a given level have been performed, the step value that gave the lowest value of the tone $f_{2th\_spur}$ power is applied as a correction value and begins to be part of the calibration signal $DAC_{cal}$.

During the subsequent calibration iterations, this value is gradually corrected more and more with values increasingly closer to the ideal value: indeed, during the successive calibration iterations, the voltages points, where the correct value of calibration is searched, are increasingly closer to the previously found point.

To better understand how the sequencer 231, e.g. the procedure Sequencer operates the calibration, it is considered a simple case of a DAC 113 with only one level mismatched. In Figure 6 it is depicted what happens during the calibration. On the horizontal axis is indicated the output voltage DAC'$_{out}$ of the calibrated DAC 113', while the arrow pointing down from the horizontal axis represents spurs originated by the sequence of correction values $Steps_{Table}(k)$ with calibration order Order=11, thus k goes from 0 to 9, and the sequence goes from $Steps_{Table}(k)=-S*Step_{cal}$ to $+5*Step_{cal}$ increasing of one calibration step $Step_{cal}$ at a time, with the exception of $Steps_{Table}(5)$, i.e. the central element of the sequence, which is increased of $2*Step_{cal}$ to avoid applying a zero correction. In this example the real level, indicated with r, and corresponding to zero correction, is below the expected one, indicated with e. As mentioned, at the start of calibration, in the first measure a negative voltage (correction sequence element $Steps_{Table}(0)$) equal to $-5*step_{cal}$ is added to the real level and a measure of the power SE at the second spur frequency $f_{2th\_spur}$ is performed. This measure is stored in the memory table MT, as explained with reference to procedure Sequencer. From the second measure to the 5th one, the added voltage step is $step_{cal}$ and the result of power estimation are stored in the measure array MT. At the 6th measurement, the voltage added is equal to $2step_{cal}$ and the power of the spur after the real level r is estimated. At the end, a voltage of $-5*step_{cal}$ is added and power SE at the second spur frequency $f_{2th\_spur}$ linked to the real level r is measured and stored. Hence, the minimum of the measure array MT values is searched and in the case of the example the minimum is found at the 8th measure time (k=7, i.e., the minimum index min_index is 7) and is very near to the expected value e. In the successive iterations, i.e., with Order=7 this correction value is further adjusted.

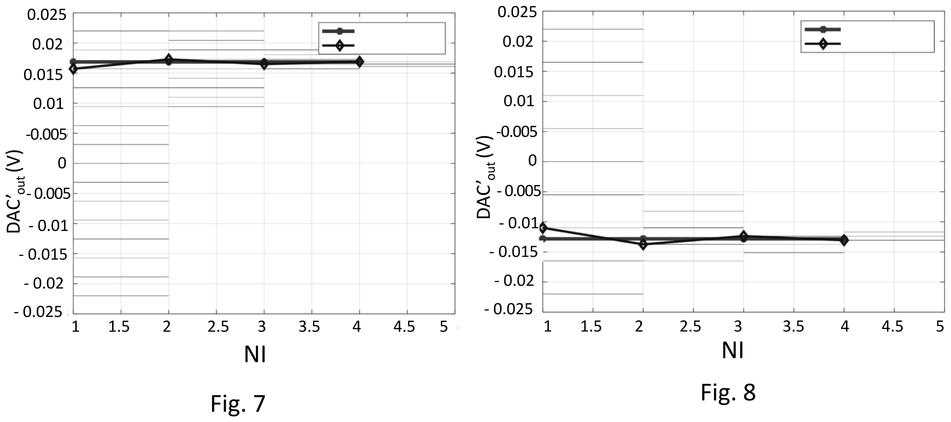

Figure 7 shows a case of a calibration of the central level of the DAC. Calibration order Order is 15. Mismatch error is 4%. In the Figure 8 it is shown the test with a Calibration order Order equal to 9. On the horizontal axis is the ordinal number of the iteration NI, while on the vertical axis is the DAC voltage output, i.e. DAC'$_{out}$. The line with the full circles is the mismatched output level of the DAC 113, while the line with the diamonds is the correction control, i.e. the calibration signal $DAC_{CAL}$ for that level. For instance in figure 7 it can be seen that the number of correction values $Steps_{Table}(k)$ and the calibration order Order decrease with the subsequent iterations NI, in a voltage range which shrinks around the mismatched level to correct.

Thus, based on the pseudocode examples above and figures 6 to 8 the operation of, on the basis on the estimated power, e.g., SE value, adjusting , e.g., 23 the output levels, e.g., DAC'$_{out}$ of the DAC$_{out}$, e.g., 113' with a calibration signal , e.g., $DAC_{cal}$ to minimize said estimated power, e.g., SE value comprises performing a level correction procedure comprises the steps of:

for each of the output levels, e.g., the $N_{level}+1$ output levels of the DAC 113' output signal, e.g., DAC'$_{out}$ of the DAC , e.g., 113' applying a sequence of increasing correction values, e.g., $Step_{table}(k)$, of calibrated voltage correction to DAC output levels,
measuring for each applied correction value, e.g., $Step_{table}(k)$ the estimated power SE of the estimated spur, e.g., $2th\_spur$, and storing it in a mismatch measurement array, e.g., M(t),
at the end of said sequence of increasing correction values , e.g., $Step_{table}(k)$, finding in said measurement array , e.g., M(t), the measured power , i.e. estimate SE, of the estimated spur, e.g., $2th\_spur$ with the minimum value, selecting., e.g. i.e. setting the minimum index min_index, the corresponding correction value, e.g., $Step_{table}$ (min_index), as calibration value in the calibration signal, e.g., $DAC_{cal}$, applied during the conversion operation to set said output level of the DAC output signal , e.g., DAC'$_{out}$. Thus, the adjustment procedure at the end sets a correction value, i.e. fixes it, in the correction table $Corr_{table}$, which contains the correction values sent in the calibration signal $DAC_{cal}$ during operation of the converter, i.e. to have a converter operating with minimum mismatch error. The calibration may be always operating or it may be performed during normal operation, triggered by the occurrence of a command or a time interval.

The previous procedure can be performed once, setting the minimum index and the correction value or values sent in the calibration signal $DAC_{cal}$ during operation of the converter, however the method provides an iteration procedure to refine the correction values, comprising selecting an order value, e.g., Order or $Order_{cal}$, and performing subsequent iterations of said calibration signal level correction procedure, updating at the end of each iteration for each level the calibration value in the calibration signal level correction procedure and decreasing the order value , e.g., Order, till the order value, e.g., Order reaches a threshold at which iterations are stopped and the current calibration value, e.g., $Step_{table}$ (min_index) is selected as calibration value in the calibration signal, e.g., $DAC_{cal}$ applied during the conversion operation to set said output level of the DAC output signal , e.g., DAC'$_{out}$.

In particular, a length of said sequence of increasing correction values, e.g., $Step_{table}(k)$, and an output signal, e.g., voltage, difference, e.g., $Step_{cal}$ between each pair of correction values, e.g., $Step_{table}(k)$, being proportional to said order value, e.g., *Order.*

In particular, said decreasing includes dividing by two said order value, e.g., Order. Also the Order is chosen as an odd integer.

Regarding the implementation actuation of correction, to simplify, with reference to figure 9, it is a considered a 1st order Sigma Delta ADC: the DAC 113' output is a current $I_{DAC}$. The DAC 113' is of the resistive type, comprises a series of resistors $R_{DAC}$ with switches SW controlled in their opening and closing status to couple the resistors $R_{DAC}$ to either a positive reference voltage VREFP or to a ground voltage VREFM. Coupling to a common mode voltage VCM is also possible. The digital input, i.e. $ADC_{out}(n)$ selects the coupling of each resistor $R_{DAC}$ to obtain the desired value of the DA output current $I_{DAC}$, depending on the applied voltage, e.g. VREFP, and an equivalent voltage $R_{eq} = R_{DAC}+R_{switch}$. If the resistors $R_{DAC}$ are not perfectly equal, a DAC mismatch in the output currents $I_{DAC}$ is generated. To correct this mismatch of the resistor $R_{DAC}$, switch resistors $R_{switch}$ have been added according to the solution: controlling the values of the switch resistors $R_{switch}$ it is possible to have equivalent resistances $R_{eq} = R_{DAC}+R_{switch}$ that are near to the ideal equality. Figure 9 shows the proposed architecture for an 8 bit DAC, where the loop filter 111 and the ADC 112 including its sample and hold circuit 112a feed bac an ADC 113 comprising such resistors $R_{DAC}$ with switches SW commanded by the digital input, i.e. $ADC_{out}(n)$. Reference voltage is a differential voltage with a maximum reference voltage VREFP and a minimum reference voltage VREFM. In the magnification of a part of the DAC 113 in figure 9 it can be seen that each resistor $R_{DAC}$ is coupled through two switches SW, one to the maximum reference voltage VREFP, which can be for instance $+V_{REF}$, and the other to the minimum reference voltage VREFM, which can be for instance $-V_{REF}$. Each switch SW has a variable switch resistance $R_{switch}$.

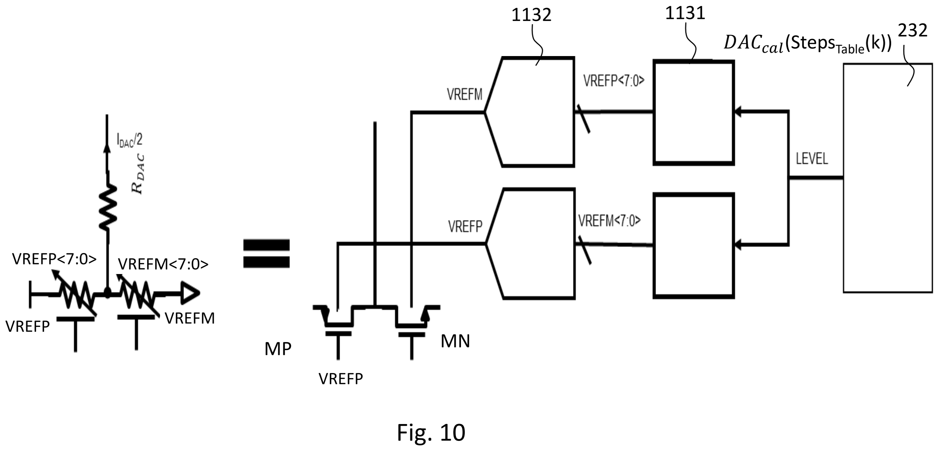

As shown in figure 10, an implementation can provide that the DAC level control 232 provides a correction value $Steps_{Table}(k)$, e.g., as shown the calibration step *step_{cal}* or a multiple of it, as calibration signal $DAC_{cal}$, which is provided as digital signal, this being correction value for a specific level, as shown for instance in figure 6.

The correction value in the calibration signal $DAC_{cal}$ is sent in parallel to two decoder 1131, which decode voltage levels, one providing a digital maximum reference voltage correction, e.g. 8bit VREFP<7:0>, i.e. a 8 bit value between 0 and VREFP, and the other providing a digital minimum reference voltage, VREFM<7:0>, an 8 bit value between 0 and VREFM, then two respective DAC 1132 convert them in the corresponding analog maximum control voltage VREFP and minimum control voltage VREFM, which are applied to the back gate of respective FD-SOI n MOSFET MN and a p MOSFET MP.

Using the FD-SOI technology the variable switch resistance $R_{switch}$ is obtained through the back gate usage. To each FD SOI MOSFET, n MOSFET MN and a p MOSFET MP it can be applied a respective back gate voltage, VBBN and VBBP. Applying the analog control voltages VREFP and VREFN as back gate voltages, VBBN and VBBP, is it possible to change, in a way per se known their drain source transconductance, $gm_{DS}$ generating in this way a controlled resistance, i.e., switch resistance $R_{switch}$, in series with the resistor $R_{DAC}$. In particular, by varying through the digital words VREFP<7:0> and VREFM<7:0> the bulk voltage of the n MOSFET MN and a p MOSFET MP is possible to tune their threshold voltage Vth of the transistors as shown, changing thus their drain source transconductance, $gm_{DS}$.

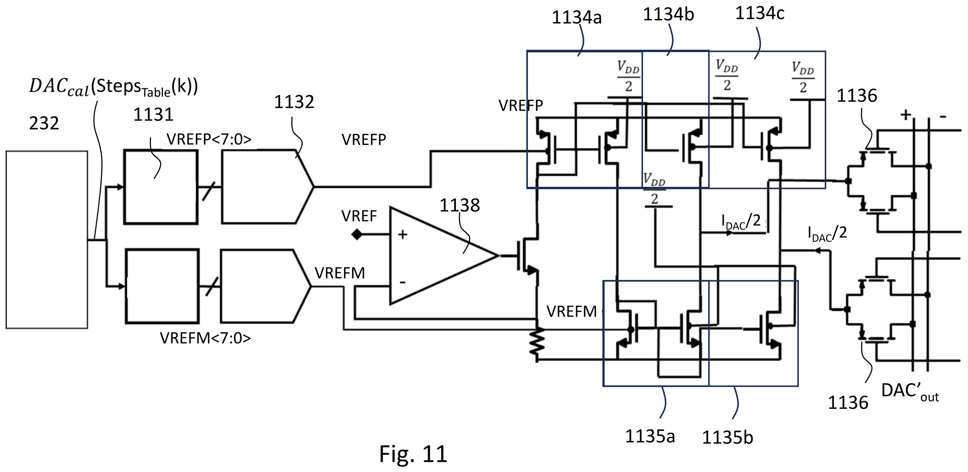

In figure 11 it is shown the implementation in a current steering DAC, which in a way per se known includes a plurality of current generators, embodied by current mirrors with p MOSFET, 1134a, 1134b, 1134c, in parallel, which voltage supply is the voltage supply VDD, while the bulk electrode of their MOSFET is coupled to the voltage supply VDD/2, with the exception of the bulk electrode of the input MOSFET of mirror 1134a, the one coupled to a buffer amplifier 1138, which is coupled to the maximum reference voltage VREFP, and current mirrors 1135a, 1135b, coupled to the output of mirror 1134a and having their output in common with the output of mirrors 1134b and 1134c respectively, with the input n MOSFET of mirror 1135a having the bulk electrode coupled to the minimum reference voltage VREFM and the other to VDD/2. Switches 1136 couple the outputs an analog output current, $I_{DAC}/2$, supplied by the MSB or LSB current generators, to the differential analog output signal $DAC'_{out}$. A reference signal VREF is brought through a buffer amplifier 1138. The operation of such circuit, where each current generator is controlled by a bit of the input digital word, contributing a given amount of current to the output current IDAC, is in general known. The relevant aspect is that the mismatch of MOSFETs in the current mirrors generate a mismatch in the output currents $I_{DAC}$. Thus, according to the solution here described, the MOSFET in the current mirrors are FD SOI MOSFET, either n or p, with back gate voltage, like in figuree9. Therefore, also in this case adjusting the back gate voltage of the MOSFETs the mismatch can be corrected. As shown, the same correction chain comprising modules 232, 1131, 1132 provides the correction voltages VREFP and VREFN to the back gate of the MOSFET n and p respectively in the current mirrors.

The back gates of the mirror MOSFET are supplied to Vdd/2 (half of the digital supply voltage), and the back gate of diode Mos are driven by the correction DAC, i.e. the chain of modules 232, 1131, 1132. By way example, a resistance variation of the n MOSFET and p MOSFET e.g. +/-2.5% is obtainable changing the voltages VREFP and VREFM, i.e. the back-gate voltages, this being able to recover an overall mismatch (static and dynamic) of the same amount.

Thus, regarding this aspect, summarizing the conversion architecture here described, e.g., 20, 20', may perform the calibration by an internal digital to analog converter, e.g. the converter 113' which is configured to be calibrated, comprising an arrangement of back-gated MOSFET, such as MP, MN in the resistive DAC of figures 9, 10 or current mirror MOSFETs 1134, 1135 in the steering current DAC of figure 11, in particular FD-SOI MOSFET, determining the output of said internal digital to analog converter, 113', based on the output digital signal $ADC_{out}$ at its input, such output adjustment arrangement, e.g. the chain of decoder 1131 and DAC 1132 coupled to the module 232, being configured to send said calibration signal, i.e. $DAC_{CAL}$, which includes the correction values $Steps_{Table}$, to the back gates of said back-gated MOSFET, e.g., MP, MN or 1134, 1135 to modify their transconductance, e.g., $g_{mDS}$, i.e., their resistance or their current output.

From the description here above thus the advantages of the solution described are clear.

Advantageously, the solution described allows that during the calibration period the converter can be operated on the input signal.

Moreover, the proposed solution is adaptive to process/temperature variations.

This obtained since the architecture generates a calibration tone which generates spurs on the input of the ADC and includes a calibration unit to adjust the DAC operation in a way which minimizes such spurs.

The technique is implemented in a standard CMOS process, which is also the best process choice for low power consumption.

Without prejudice to the underlying principles, the details and embodiments may vary, even significantly, with respect to what has been described by way of example only, without departing from the extent of protection.

The extent of protection is defined by the annexed claims.

**Claims**

1. A conversion architecture (10) comprising a Continuous Time Sigma Delta Analog to Digital Converter (11) comprising a loop filter (111) followed by an analog to digital converter (112) and a feedback loop (113, 113', 116) feeding back the output (v) of said analog to digital converter (112) through an internal digital to analog converter (113; 113') to obtain (110) an error signal (e(t)) with respect to a input signal (*u, s(t)*), which is fed to said loop filter (111), an output digital signal ($ADC_{out}$) of the analog to digital converter (112) being fed to a decimation chain of decimators (14), a local oscillator (12) feeding a clock signal ($CLK_{ADC}$) to said analog to digital converter (112), and, through a frequency divider (13), to said chain of decimators (14), wherein said conversion architecture (10) further comprises

   a circuit arrangement (116; 116, 24) configured to obtain a calibration tone (CT) by a divided frequency (CK3) outputted by said frequency divider (13) to said chain of decimators (14) and inject said calibration tone (CT) in said feedback loop (113', 116), in particular in the input path of said analog to digital converter (112),
   a calibration arrangement (22, 23) which comprises

   a spurious tone estimation module (22) configured to obtain an estimation (SE) of the power of a spurious tone (2th_spur) in said output signal (v) based on a decimated signal ($v_1$) taken in said decimation chain (14), and
   a calibration unit (13) receiving said estimation (SE) of the power of a spurious tone (2th_spur) and configured to send a calibration signal ($DAC_{CAL}$) as function of said estimation (SE) of the power of a spurious tone to said digital to analog converter (113'), which comprises an output adjustment arrangement (115; 1131, 1132) configured to adjust an output signal ($DAC'_{out}$) of said internal digital to analog converter (113) based on said a calibration signal ($DAC_{CAL}$).

2. A conversion architecture according to claim 1, wherein said spur estimation module (22) comprises a filter (222) configured to filter around a selected spur (2th_spur) to which output is coupled a module (225) configured to calculate a FFT power spectrum ($SFF^2$) of said selected spur (2th_spur), to which output is coupled a module (226) configured to calculate spur estimation (SE) as a maximum amplitude of said FFT power spectrum ($SFF^2$).

3. A conversion architecture according to claim 1 or 2, wherein said calibration unit (22) comprises a sequencer module (231) which receives said spur estimation (SE) and calculates correction values on the basis of said spur estimation value and a DAC level control module (23) configured to receive said correction values and to issue a corresponding calibration signal ($DAC_{CAL}$) to said output adjustment arrangement (115; 1131, 1132) configured to adjust an output signal ($DAC'_{out}$) of said internal digital to analog converter (113').

4. A conversion architecture according to claim 3, wherein said sequencer module (231) is configured to compute one or more sequence of correction values ($Stept_{able}(k)$) for each an output level of said DAC (113'), and upon issuance as calibration signal ($DAC_{CAL}$) by said DAC level control module (232) configured to said output adjustment arrangement (115; 1131, 1132) store the corresponding spur estimation (SE) value and find the correction value which minimize spur estimation (SE).

**5.** A conversion architecture according to any of the preceding claims, wherein said internal digital to analog converter (113') comprises an arrangement of back-gated MOSFET (MP, MN; 1134, 1135), in particular FD-SOI MOSFET, determining the output of said internal digital to analog converter (113') based on the output digital signal ($ADC_{out}$) at its input, said output adjustment arrangement (115; 1131, 1132) being configured to send said calibration signal ($DAC_{CAL}$) to the back gates of said back-gated MOSFET (MP, MN; 1134, 1135) to modify their transconductance.

**6.** A calibration method of the conversion architecture of any of claims 1 to 5, comprising

- generating a calibration tone (CT) with an out-of-band frequency, compared to a baseband signal of said conversion architecture (20; 20')
- injecting said calibration tone (CT) in the input path of the analog to digital converter (112);
- taking a version analog to digital converter (112) output signal ($v_1$);
- estimating (22) the power (SE) of a spurious tone (2th-spur) selected in the taken version of the output signal ($v_1$);
- on the basis on the estimated power (SE) value, adjusting (23) the output levels ($DAC'_{out}$) of the DAC (113') with a calibration signal ($DAC_{cal}$) to minimize said estimated power (SE) value.

**7.** A calibration method according to claim 6, wherein said operation of, on the basis on the estimated power (SE) value, adjusting (23) the output levels ($DAC'_{out}$) of the DAC (113') with a calibration signal ('$DAC_{cal}$) to minimize said estimated power (SE) value comprises performing a level correction procedure comprising the steps of:

for each of the output levels ($N_{level}+1$) of the DAC output signal ($DAC'_{out}$) of the DAC (113') applying a sequence of increasing correction values ($Stept_{able}(k)$) of calibrated voltage correction to DAC output levels, measuring for each applied correction value ($Stept_{able}(k)$) the estimated power (SE) of the estimated spur (2th_spur) and storing it in a measurement array (M(t)), at the end of said sequence of increasing correction values ($Step_{table}(k)$) finding in said measurement array (M(t)) the measured power (SE) of the estimated spur (2th_spur) with the minimum value, select (min index) the corresponding correction value ($Step_{table}(min\_index)$) as calibration value in the calibration signal ($DAC_{cal}$) applied during the conversion operation to set said output level of the DAC output signal ($DAC'_{out}$).

**8.** A calibration method according to claim 7, comprising selecting an order value (*Order*) and performing subsequent iterations of said calibration signal level correction procedure, updating at the end of each iteration for each level the calibration value in the calibration signal level correction procedure and decreasing the order value (*Order*), till the order value (*Order*) reaches a threshold at which iterations are stopped and the current calibration value ($Step_{table}$ (min_index)) is selected as calibration value in the calibration signal ($DAC_{cal}$) applied during the conversion operation to set said output level of the DAC output signal ($DAC'_{out}$).

**9.** A calibration method according to claim 8, wherein a length of said sequence of increasing correction values ($Stept_{able}(k)$) and a voltage difference ($Step_{cal}$) between each pair of correction values ($Step_{table}(k)$) being proportional to said order value (Order).

**10.** A calibration method according to claim 8, wherein said decreasing includes dividing by two said order value (Order).

EP 4 787 714 A1

SDA

AD | DD

LOF

$e_q$

$u$ → | $y$ | $S_{ADC}$ | $v$

$v_d$

$S_{DAC}$

$e_{mm}$

a)

SDD'

DD | AD

LOF

$e_q$

$u$ → | $y$ | $v$ | $S_{DAC}$ | $v_d$

$S_{ADC}$

$e_{mm}$

b)

Fig. 1

Fig. 2

Fig. 3

Fig. 4

$V_1(2th\_spur)$ → [221] → [222] $f_{2th\_spur}$ 2th_spur → [223] SFF → [223a] $|\ |^2$ SFF² → [226] SE → z⁻¹

221    222    223    223a

225

**Fig. 5**

$\text{Steps}_{\text{Table}}(0) \quad = -5 step_{cal}$

$\text{Steps}_{\text{Table}}(1) \quad = -5\, step_{cal} + step_{cal} = -4 step_{cal}$

$\text{Steps}_{\text{Table}}(2) \quad = -4 step_{cal} + step_{cal} = -3 step_{cal}$

$\text{Steps}_{\text{Table}}(3) \quad = -3 step_{cal} + step_{cal} = -2 step_{cal}$

$\text{Steps}_{\text{Table}}(4) \quad = -2 step_{cal} + step_{cal} = -step_{cal}$

$\text{Steps}_{\text{Table}}(5) \quad = -step_{cal} + 2 step_{cal} = step_{cal}$

$\text{Steps}_{\text{Table}}(6) \quad = step_{cal} + step_{cal} = 2 step_{cal}$

$\text{Steps}_{\text{Table}}(7) \quad = 2 step_{cal} + step_{cal} = 3 step_{cal}$

$\text{Steps}_{\text{Table}}(8) \quad = 3 step_{cal} + step_{cal} = 4 step_{cal}$

$\text{Steps}_{\text{Table}}(9) \quad = 4 step_{cal} + step_{cal} = 5 step_{cal}$

$3\sigma\ of\ expected\ mismatch$

r    e

$DAC'_{out}$

Fig. 6

Fig. 7

Fig. 8

EP 4 787 714 A1

$ADC_{out}(n)$

112

112a

111

110

SW

$R_{IN}$

$R_{DAC}$

$R_{DAC}$

VREFP
VCM
VREFM

113'

113'

$I_{DAC}/2$

$R_{DAC}$

VREFM<7:0>

VREFM

$I_{DAC}/2$

$R_{switch}$

$R_{DAC}$

VREFM<7:0>

VREFP<7:0>

VREFM VREFP

VREFM VREFP

$R_{switch}$

VREFP<7:0>

VREFP

$R_{eq} = R_{DAC} + R_{switch}$

Fig. 9

Fig. 10

EP 4 787 714 A1

Fig. 11

EP 4 787 714 A1

Europäisches
Patentamt

European
Patent Office

Office européen
des brevets

# EUROPEAN SEARCH REPORT

**Application Number**

EP 26 15 2022

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PAVAN SHANTHI ET AL: "Improved Offline Calibration of DAC Mismatch Errors in Delta-Sigma Data Converters", IEEE TRANSACTIONS ON CIRCUITS AND SYSTEMS II: EXPRESS BRIEFS, IEEE, USA, vol. 66, no. 10, 10 June 2019 (2019-06-10), pages 1618-1622, XP011747721, ISSN: 1549-7747, DOI: 10.1109/TCSII.2019.2921777 [retrieved on 2019-09-23] | 1,2,5,6 | INV. H03M1/10 H03M3/02 H03M3/04 H03M1/66 H03M1/08 H03M1/80 |
| A | * Sections I-III; figures 3, 6a, 7 * ----- | 3,4,7-10 | |
| A | US 11 139 826 B2 (HUAWEI TECH CO LTD [CN]) 5 October 2021 (2021-10-05) * column 14, lines 9-14; figure 7b * ----- | 1-10 | |
| A | BEAUQUIER CLEMENT ET AL: "Foreground Static Error Calibration for Current Sources Using Backgate Body Biasing", 2022 IEEE 7TH FORUM ON RESEARCH AND TECHNOLOGIES FOR SOCIETY AND INDUSTRY INNOVATION (RTSI), IEEE, 24 August 2022 (2022-08-24), pages 19-24, XP034203017, DOI: 10.1109/RTSI55261.2022.9905200 * sections II.B and III.A; figure 6a * ----- | 5 | **TECHNICAL FIELDS SEARCHED (IPC)** H03M |
|  | -/-- | | |

The present search report has been drawn up for all claims

| Place of search | Date of completion of the search | Examiner |
|---|---|---|
| The Hague | 3 June 2026 | Galardi, Leonardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**page 1 of 2**

Europäisches
Patentamt

European
Patent Office

Office européen
des brevets

Application Number

EP 26 15 2022

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE BOCK MAARTEN ET AL: "Calibration of DAC Mismatch Errors in $\Sigma\Delta$ ADCs Based on a Sine-Wave Measurement", IEEE TRANSACTIONS ON CIRCUITS AND SYSTEMS II: EXPRESS BRIEFS, IEEE, USA, vol. 60, no. 9, 8 August 2013 (2013-08-08), pages 567-571, XP011526466, ISSN: 1549-7747, DOI: 10.1109/TCSII.2013.2268413 [retrieved on 2013-09-11] * sections I, V * ----- | 1-10 | |
| | | | TECHNICAL FIELDS SEARCHED (IPC) |

The present search report has been drawn up for all claims

| Place of search | Date of completion of the search | Examiner |
|---|---|---|
| The Hague | 3 June 2026 | Galardi, Leonardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 787 714 A1**

## ANNEX TO THE EUROPEAN SEARCH REPORT
## ON EUROPEAN PATENT APPLICATION NO.

EP 26 15 2022

This annex lists the patent family members relating to the patent documents cited in the above-mentioned European search report.
The members are as contained in the European Patent Office EDP file on
The European Patent Office is in no way liable for these particulars which are merely given for the purpose of information.

03-06-2026

| Patent document cited in search report | | Publication date | Patent family member(s) | | Publication date |
|---|---|---|---|---|---|
| US 11139826 | B2 | 05-10-2021 | CN | 110086466 A | 02-08-2019 |
| | | | CN | 112671404 A | 16-04-2021 |
| | | | EP | 3736987 A1 | 11-11-2020 |
| | | | US | 2020366312 A1 | 19-11-2020 |
| | | | WO | 2019144651 A1 | 01-08-2019 |

EPO FORM P0459

For more details about this annex : see Official Journal of the European Patent Office, No. 12/82